# EUROPÄISCHE PATENTANMELDUNG

(11) **EP 1 376 177 A2**
(43) Veröffentlichungstag der Anmeldung: **02.01.2004**
(21) Anmeldenummer: 03012832.6
(22) Anmeldetag: 05.06.2003
(51) Int. Cl.: G02B 6/42

(54) **Optoelektronisches Modul**

(30) Priorität: 19.06.2002 EP 02013644
(71) Anmelder: Tyco Electronics AMP GmbH, 64625 Bensheim (DE)
(72) Erfinder: Schramm, Dieter, 75236 Kömptelbach (DE); Grenda, Dieter, 64625 Bensheim (DE); Lannoije, Mamix, 67346 Speyer (DE); Hahn, Joachim, 61389 Schmitten (DE); Berchtold, Lorenz, 90425 Nürnberg (DE); Glaser, Karlheinz, 74223 Flein (DE); Stoesser, Gerhard, 75223 Teifenbronn (DE)
(74) Vertreter: Grünecker, Kinkeldey, Stockmair & Schwanhäusser Anwaltssozietät

(57) **Zusammenfassung**

Es wird ein optoelektronisches Modul (100) und ein Verfahren zum Herstellen eines optoelektronischen Moduls vorgeschlagen, das eine optoelektronische Bauelementanordnung aufweist, die auf einem Trägerelement (3) mit wenigstens einer Leitbahn (4) aufgebracht ist und mit der Leitbahn elektrisch kontaktiert ist, wobei auf der Bauelementanordnung (2) eine Abdeckung vorgesehen ist, welche über einem lichtemittierenden Bereich oder einem lichtempfindlichen Bereich der Bauelementanordnung eine Öffnung aufweist, in die ein optischer Verbinder einkoppelbar ist, wobei das Trägerelement thermoplastisch umspritzt ist, um einen Gehäusebehälter auszubilden, in den die Bauelementanordnung einbringbar ist. Gemäß einer zweiten Ausführungsform der Erfindung wird ein optoelektronisches Modul und ein Verfahren zum Herstellen des optoelektronischen Moduls vorgeschlagen, in dem die Bauelementanordnung und das Trägerelement so mit einem aushärtbaren Material umgossen sind, dass ein Gießkörper ausgebildet ist, wobei der Gießkörper von einer umspritzten Gehäuseabdeckung ummantelt ist.

## Beschreibung

Die vorliegende Erfindung betrifft ein optoelektronisches Modul, das eine optoelektronische Bauelementanordnung aufweist, die auf einem Trägerelement mit wenigstens einer Leitbahn aufgebracht und mit der Leitbahn elektrisch kontaktiert ist, wobei auf der Bauelementanordnung eine Abdeckung vorgesehen ist, welche über einem lichtemittierenden Bereich oder einem lichtempfindlichen Bereich der Bauelementanordnung eine Öffnung aufweist, in die ein optischer Verbinder einkoppelbar ist.

In der Automobilentwicklung ist ein eindeutiger Trend dahingehend zu beobachten, elektronische Systeme anstatt mechanischer Komponenten einzusetzen, immer mehr Komfort- und Sicherheitsfunktionen zu realisieren und gleichzeitig Rücksicht auf die Umwelt zu nehmen. Dies ist mit einer steigenden Komplexität der Fahrzeugelektronik bei gleichzeitig wachsender Anzahl von Funktionen, Sensoren und Aktoren verbunden. Diese Anforderungen sind mit einem zentralen Steuergerät nicht zu realisieren. Eine Lösung hierfür besteht in einer Vernetzung der verschiedenen Elektronikbaugruppen über einen Hochleistungs-Datenbus zur Reduzierung des Verkabelungsaufwands und zur Mehrfachnutzung von Sensordaten.

Bei der Entwicklung eines solchen Hochleistungsdatenbussystems kommt dem Aspekt der elektromagnetischen Verträglichkeit wegen der hohen zu verarbeitenden Datenrate eine besondere Bedeutung zu. Elektrische Verbindungsleitungen müssen mit besonderen Maßnahmen vor externen Störeinflüssen geschützt werden. Dies geschieht meist durch die Verwendung von beschirmten oder verdrillten Leitungen. Trotz des damit verbundenen hohen Fertigungs- und damit Kostenaufwands ist eine galvanische Trennung der einzelnen Systemskomponenten nicht möglich. Deshalb wurde ein Bussystem entwickelt, das auf der Kunststoff-Lichtwellenleiter-Technik (plastic optical fiber: POF) basiert.

Die optische Übertragung hat bei Datenbus-Systemen den Vorteil, dass sie von elektromagnetischen Störeinflüssen verschont bleibt. Zudem sind die verbundenen Systemkomponenten galvanisch voneinander getrennt, wodurch eine ungewollte gegenseitige Beeinflussung der einzelnen Module ausgeschlossen wird.

Die einzelnen Teilnehmer des Datenbussystems sind über jeweils einen Lichtwellenleiter (LWL) und einen aktiven Sternkoppler miteinander verbunden. Im Sternkoppler ist zur Anbindung jedes Teilnehmers ein optischer Transceiver-Baustein vorgesehen, in den eine Sende- und Empfangsdiode sowie ein Transceiver-Chip integriert sind, in welchem eine LED-Treiberschaltung, ein Empfangsverstärker und einige Logik- und Diagnosefunktionen enthalten sind. Die Sende- und die Empfangsdiode des Transceivers sind in Chip-on-Chip-Technologie übereinander montiert, um eine optimale Kopplung beider Bauteile an den Lichtwellenleiter zu erreichen.

In dem Datenbussystem ist es möglich, dass die Transceiver-Bausteine direkt in Steuergeräte-Stiftleisten integriert werden, womit die Koppelverluste optimiert werden und auf einen kostenintensiven Justiervorgang verzichtet werden kann. Hierfür besteht ein Bedarf an Spezialgehäusen für die Transceiver. An diese werden hohe Anforderungen hinsichtlich Reproduzierbarkeit, Zuverlässigkeit und Haltbarkeit gestellt, um eine Automatisierung der Stiftleistenmontage und gleichzeitig eine hochgenaue Positionierung der leitungsseitigen Stiftelemente zu ermöglichen. Parallel dazu muss solch ein Spezialgehäuse eine langzeitstabile und dichte Verbindung zwischen den optoelektronischen Bauelementen und eingekoppelten Lichtwellenleitern aufweisen.

Ein Standardverfahren zum Einkapseln mikroelektronischer Bauelemente ist das sogenannte Transfermolding. Dabei wird ein Trägerstreifen (leadframe) mit darauf gebondeten Bauelementen in ein Spritzwerkzeug eingelegt und mit einem Duroplast umspritzt. Um beispielsweise Dioden zu fertigen, kann hierfür ein durchsichtiges Duroplast verwendet werden.

Weiterhin ist das sogenannte Pottingverfahren bekannt. Dabei wird ein Behälter mit einem Zwei-Komponenten-Epoxidharz gefüllt und anschließend ein mit Bauelementen bestücktes leadframe in den Behälter getaucht. Das Epoxidharz wird ausgehärtet und das fertige Modul (leadframe, Bauelemente und Epoxidharz) aus dem Behälter entfernt. Um Dioden einzukapseln, wurde dieses Verfahren so abgeändert, dass der Tauchbehälter eine sogenannte "Cavity as Interface" (CAI) mit einem Stempel ist, der sich an der Stelle befindet, an der die Diode mit einem Lichtwellenleiter gekoppelt werden soll. Aus Genauigkeitsgründen wird in dieser abgeänderten Technologievariante der Behälter nicht von dem Harz entfernt.

Mit den obengenannten herkömmlichen Technologien ist es nur unter hohem Auffand möglich, die optoelektronischen Bauelemente genau zum Lichtwellenleiter zu justieren und eine dauerhaft stabile Kopplung zwischen diesen Elementen herzustellen. Des Weiteren ist jeweils eine Vielzahl umständlicher Verfahrensschritte notwendig, die den Prozessablauf verlängern und verteuern. Zudem erreichen die gefertigten Module häufig nicht die geforderte Reproduzierbarkeit, um sie einfach an externe Systemelemente anbinden zu können.

Es ist daher eine Aufgabe der Erfindung, ein optoelektronisches Modul und ein Verfahren zum Herstellen eines optoelektronischen Moduls zur Verfügung zu stellen, welche einfach und kostengünstig sind und dennoch ein hochgenaue Justierung der Bauelemente zu einem optischen Verbinder ermöglichen, wobei zusätzlich das Modul einfach an weitere Systemelemente anbindbar ist.

Die Aufgabe wird erfindungsgemäß durch ein optoelektronisches Modul gelöst, das eine optoelektronische Bauelementanordnung aufweist, die auf einem Trägerelement mit wenigstens einer Leitbahn aufgebracht und mit der Leitbahn elektrisch kontaktiert ist, wobei auf der Bauelementanordnung eine Abdeckung vorgesehen ist, welche über einem lichtemittierenden Bereich oder einem lichtempfindlichen Bereich der Bauelementanordnung eine Öffnung aufweist, in die ein optischer Verbinder einkoppelbar ist, dadurch gekennzeichnet, dass das Trägerelement thermoplastisch umspritzt ist, um einen Gehäusebehälter auszubilden, in den die Bauelementanordnung einbringbar ist.

Das erfindungsgemäße optoelektronische Modul besitzt den Vorteil, dass die optoelektronische Bauelementanordnung bereits in ein um das Trägerelement ausgebildetes, vorgefertigtes Kunststoffgehäuse mit hoher Präzision eingebracht werden kann. Zusätzlich bildet der Gehäusebehälter bereits von Anfang an einen Schutz für die optoelektronischen Bauelemente. Der vor dem Einbringen der Bauelementanordnung ausgefertigte Gehäusebehälter kann zudem sehr genaue äußere Abmessungen aufweisen, wodurch dessen Anbindbarkeit an weitere oder externe Systemelemente erleichtert wird. Außerdem besitzt das optoelektronische Modul einen einfachen Aufbau und ist kostengünstig herstellbar.

In einer vorteilhaften Ausführungsform der Erfindung kann das Trägerelement ein gestanzter Trägerstreifen oder wenigstens ein Teil einer gedruckten Leiterplatte sein.

Hiermit wird eine geeignete Unterlage zum Aufbringen der Bauelementanordnung zur Verfügung gestellt, deren Anschlüsse mit den Leiterbahnen des gestanzten Trägerstreifens oder der gedruckten Leiterplatte verbindbar sind.

In einer günstigen Variante der Erfindung kann das Trägerelement so thermoplastisch umspritzt sein, dass das Trägerelement so in den Gehäusebehälter eingebettet ist, dass die Oberfläche des Trägerelementes offen liegt.

Damit wird das Trägerelement bis auf die offenliegende Seite durch den Gehäusebehälter geschützt. Außerdem erlaubt die offene Oberfläche ein einfaches Aufbringen der Bauelemente auf das Trägerelement.

Gemäß einer bevorzugten Ausführungsform der Erfindung kann der Gehäusebehälter einen Gehäuseboden und einen Gehäuserahmen mit mehreren, sich von dem Trägerelement etwa im rechten Winkel erstreckenden Rahmenseiten aufweisen.

Hiermit wird dem Gehäusebehälter eine Form verliehen, welche einfach an weitere Systemkomponenten anpassbar ist.

Gemäß einer weiteren günstigen Variante der Erfindung können die Rahmenseiten einen etwa rechteckigen Gehäuserahmeninnenraum ausbilden.

Durch die einfache Geometrie des Gehäuserahmeninnenraums ist eine leichte Positionierung der Bauelementanordnung relativ zu dem Gehäusebehälter möglich.

In einer vorteilhaften Ausführungsform der Erfindung kann der Gehäuserahmen in dem Gehäuserahmeninnenraum Versteifungsrippen aufweisen.

Die Versteifungsrippen verleihen dem Gehäuserahmen eine erhöhte Stabilität, wodurch eine erhöhte Reproduzierbarkeit der äußeren Abmessungen des Gehäusebehälters gewährleistet wird.

Gemäß einem vorteilhaften Beispiel der Erfindung können wenigstens zwei Versteifungsrippen gekreuzt angeordnet sein.

Mit dieser Anordnung wird eine verstärkte Stabilität des Gehäuserahmens erreicht.

Gemäß einer weiteren bevorzugten Ausführungsform der Erfindung kann wenigstens eine Rahmenseite zumindest eine Durchführung für einen Leitbahnanschluss der Leitbahn aufweisen.

Hiermit kann die wenigstens eine Leitbahn des Trägerelementes nach außen kontaktiert werden, wodurch eine elektrische Verbindungsmöglichkeit zum optolelektronischen Modul hergestellt wird.

Günstigerweise kann der Leitbahnanschluss eine Stiftleiste sein.

Eine Stiftleiste kann eine Vielzahl von Anschlüssen in normierten Abständen aufweisen und kann dadurch beispielsweise einen kompatiblen Anschluss zu weiteren Baugruppen oder Bauelementen gewährleisten.

Vorzugsweise kann wenigstens eine Rahmenseite einen Kühlungsanschluss aufweisen, der mit dem Trägerelement verbunden ist.

Hierdurch kann die optoelektronische Bauelementanordnung auf dem Trägerelement gekühlt werden, wodurch die Bauelemente vor einem Überhitzen geschützt werden können und eine höhere Effizienz der Anordnung verbunden mit einer gesteigerten Lebensdauer erzielt werden kann.

In einer besonders vorteilhaften Variante der Erfindung kann eine Rahmenseite einen Schirmungsanschluss zum elektrischen Abschirmen der optoelektronischen Bauelementanordnung aufweisen, der mit dem Trägerelement verbunden ist.

Damit kann die optoelektronische Bauelementanordnung elektromagnetisch von außen abgeschirmt werden, wodurch Störungen oder Ausfälle der optoelektronischen Bauelementanordnung verringert werden können.

In einer besonders günstigen Variante der Erfindung kann der Gehäusebehälter die Form eines Einschubfaches aufweisen, bei dem eine Rahmenseite im Vergleich zu der ihr gegenüberliegenden Rahmenseite beidseitig verlängerte Seitenkantenbereiche aufweist.

Hiermit kann der Gehäusebehälter als ein Schubmodul eingesetzt werden, welches beispielsweise in weitere Baugruppen oder Gehäuseanordnungen einfach eingebracht werden kann.

In einem besonders bevorzugten Beispiel der Erfindung kann das Trägerelement so thermoplastisch umspritzt sein, dass wenigstens ein Abschnitt des Trägerelementes außerhalb des umspritzten Bereiches ist.

Auf einem solchen Abschnitt können beispielsweise zusätzliche Bauelemente oder Vorrichtungen vorgesehen werden, welche die Funktion der optoelektronischen Bauelementanordnung ergänzen, erweitern, schützen, absichern oder deren Langzeitstabilität verbessern. Auf diese Weise sind diese zusätzlichen Elemente oder Vorrichtungen von der eigentlichen optoelektronischen Bauelementanordnung durch wenigstens eine Wand des umspritzten Bereiches getrennt.

Vorzugsweise kann das Trägerelement ein Referenzelement zum Ausrichten der optoelektronischen Bauelementanordnung auf dem Trägerelement aufweisen.

Hiermit kann die Genauigkeit des Aufbringens der optoelektronischen Bauelementanordnung auf das Trägerelement erhöht werden, wodurch eine Toleranzkette aufgebaut werden kann, welche die Reproduzierbarkeit der Abmessungen des optoelektronischen Moduls verbessern kann.

Es wird weiter vorgeschlagen, dass das Referenzelement eine innerhalb des Gehäusebehälters ausgebildete Kunststoffkante ist.

An diese Kunststoffkante können die Bauelemente angelegt oder relativ zu ihr justiert werden. Beispielsweise könnte die Kunststoffkante bereits beim Umspritzen des Trägerelementes als Teil des Gehäusebehälters ausgebildet werden.

Vorteilhafterweise kann die Erfindung so ausgestaltet sein, dass die Kunststoffkante eine Trennwand zwischen einzelnen Bauelementen der optoelektronischen Bauelementanordnung ausbildet.

Hiermit können die einzelnen Bauelemente separat zueinander justiert werden. Beispielsweise können hiermit auch einzelne Bauelemente oder Bauelementgruppen mit einem Abdeckmaterial abgedeckt werden, während die durch die Trennwand abgetrennten Bauelemente nicht abgedeckt werden.

Als weitere vorteilhafte Variante der Erfindung wird vorgeschlagen, dass die Höhe des Referenzelementes geringer als die der Gehäuseseiten ist.

Somit kann die optoelektronische Bauelementanordnung gemeinsam mit dem Referenzelement in dem Gehäusebehälter abgedeckt werden, wodurch eine ebene Oberfläche des Gehäusebehälters ausgebildet werden kann, auf die die Abdeckung justiergenau aufgebracht werden kann.

Gemäß einer weiteren bevorzugten Ausführungsform der Erfindung kann die Bauelementanordnung wenigstens einen Receiver und/oder einen Transmitter aufweisen.

Somit kann die Bauelementanordnung optische Signale empfangen und/oder aussenden.

In einer besonders bevorzugten Ausführungsform der Erfindung kann der Receiver und der Transmitter einen Transceiver ausbilden, in dem der Transmitter und der Receiver übereinander angeordnet sind.

Mit einer solchen Anordnung können die Signalverluste minimiert werden. Auch kann der Platzbedarf auf dem Trägerelement reduziert werden.

Vorzugsweise kann der Receiver eine Fotodiode sein.

Damit ist die optoelektronische Bauelementanordnung in der Lage, optische Signale in elektrische umzuwandeln.

Vorteilhafterweise kann der Transmitter eine Lichtemitterdiode sein.

Hiermit können mit Hilfe der optoelektronischen Bauelementanordnung elektrische Signale in optische umgewandelt werden.

In einem bevorzugten Beispiel der Erfindung kann die Bauelementanordnung wenigstens einen elektronischen Steuerschaltkreis aufweisen.

Mit diesem Steuerschaltkreis können die Funktionen der optoelektronischen Bauelemente gesteuert werden.

Gemäß einem weiteren bevorzugten Beispiel der Erfindung kann der Steuerschaltkreis mit einem Passivierungsmaterial abgedeckt sein.

Das Passivierungsmaterial kann den Steuerschaltkreis gegenüber Einflüssen aus seiner Umgebung schützen.

In einer günstigen Variante der Erfindung kann das Passivierungsmaterial UV-undurchlässig sein.

Hiermit wird der Steuerschaltkreis vor UV-Strahlen geschützt, wodurch Störungen oder Ausfälle des Steuerschaltkreises verringert werden können.

In einer vorteilhaften Ausführungsform der Erfindung kann das Passivierungsmaterial elektrisch oder elektromagnetisch isolierend sein.

Somit kann erreicht werden, dass der Steuerschaltkreis vor elektrischen oder elektromagnetischen äußeren Einwirkungen geschützt ist, wodurch die Zuverlässigkeit und Stabilität des Steuerschaltkreises erhöht wird.

Gemäß einer weiteren bevorzugten Ausführungsform der Erfindung kann die Bauelementanordnung mit einem Gel abgedeckt sein.

Ein solches Gel kann die Bauelementanordnung vor äußeren Einwirkungen schützen.

Vorzugsweise kann zumindest der Bereich des Gehäusebehälters, in dem sich die Bauelementanordnung befindet, mit Gel gefüllt sein.

Hiermit wird insbesondere der Bauelementanordnung durch das Gel ein geeigneter Schutz verliehen. Zudem können andere Bereiche des Gehäusebehälters frei von Gel belassen werden.

Vorzugsweise kann das Gel elastisch sein.

Ein elastisches Gel verschafft der vergossenen Anordnung eine ausreichende Flexibilität. Beispielsweise kann mit einer solchen Ausführungsform im Zusammenhang mit anderen Baugruppen eine hohe Dichtheit zwischen dem elastischen Gel und einer weiteren Baugruppe erzielt werden.

Gemäß einer weiteren bevorzugten Ausführungsform der Erfindung kann das Gel lichtdurchlässig sein.

Hiermit kann Licht durch das Gel zu der Bauelementanordnung vordringen bzw. von der Bauelementanordnung durch das Gel nach außen gelangen.

Vorzugsweise kann die Abdeckung eine Umhäusung sein.

Mit einer Umhäusung kann der gesamte Gehäusebehälter ummantelt werden.

In einer günstigen Variante der Erfindung kann die Umhäusung in Form eines Schiebedeckels ausgebildet sein, der so auf den Gehäusebehälter aufgeschoben ist, dass sich seine Öffnung über dem lichtemittieren Bereich oder dem lichtempfindlichen Bereich der optoelektronischen Bauelementanordnung befindet.

Dadurch kann die Öffnung der Abdeckung genau über dem lichtempfindlichen oder lichtemittierenden Bereich der optoelektronischen Bauelementanordnung positioniert werden.

In einem bevorzugten Beispiel der Erfindung kann der Schiebedeckel wenigstens ein Toleranzausgleichselement aufweisen, das den Gehäuserahmen mit seiner Sichtseite gegen die Öffnungsseite des Schiebedeckels drückt.

Damit kann unabhängig von Fertigungstoleranzen die Sichtseite des Gehäuserahmens nahe der Öffnung des Schiebedeckels positioniert werden. Dies kann dem optoelektronischen Modul eine verbesserte Dichtheit verleihen.

Es wird weiter vorgeschlagen, dass das Toleranzausgleichselement wenigstens zwei sich in den Schiebedeckelinnenraum längs der Schieberichtung erstreckende Schienen aufweist.

Die Schienen können beidseitig entlang der Schieberichtung den Gehäusebehälter gegen den Schiebedeckel drücken, wodurch eine noch bessere Dichtheit erzielt werden kann.

In einem bevorzugten Beispiel der Erfindung können die Schienen einen etwa dreieckigen Querschnitt aufweisen.

Insbesonders die Spitze des Dreiecks kann sich leicht in den Gehäusebehälter eindrücken, wodurch etwaige Fertigungstoleranzen ausgeglichen werden können.

Gemäß einer weiteren bevorzugten Ausführungsform der Erfindung kann im Schiebedeckel wenigstens ein Führungselement vorgesehen sein, das in ein Führungsgegenstück im Gehäusebehälter eingreift.

Damit wird das Einschieben des Gehäusebehälters in den Schiebedeckel bzw. das Aufschieben des Schiebedeckels auf den Gehäusebehälter erleichtert. Außerdem kann der Schiebedeckel relativ zu dem Gehäusebehälter leichter justiert werden.

Vorzugsweise kann der Schiebedeckel an der Öffnung einen Ringschnapphaken zum Aufnehmen des optischen Verbinders aufweisen.

Auf diese Weise kann ein optischer Verbinder, beispielsweise ein Lichtwellenleiter, einfach in die Öffnung eingebracht und aus der Öffnung entfernt werden, um eine leichte Verbindung oder Abkopplung zu bzw. von der optoelektronischen Bauelementanordnung zu ermöglichen.

In einer günstigen Variante der Erfindung kann der Schiebedeckel mit dem Gehäusebehälter verschweißt sein.

Hiermit wird eine ausreichende Dichtheit des optoelektronischen Moduls nach außen realisiert, wodurch insbesondere der Gehäusebehälterinnenraum beispielsweise vor eindringender Feuchtigkeit oder Schmutz geschützt wird.

Gemäß einem vorteilhaften Beispiel der Erfindung kann der Schiebedeckel und/oder der Gehäusebehälter zumindest teilweise mit einer leitfähigen Schicht beschichtet sein.

Die leitfähige Schicht kann dabei als Abschirmung für die sich in dem Gehäusebehälter befindliche optolektronische Bauelementanordnung dienen.

In einer weiteren vorteilhaften Ausführungsform der Erfindung kann der Gehäusebehälter wenigstens zweigeteilt sein, wobei ein erster Hohlraum zumindest über einem lichtemittierenden Bereich eines ersten optoelektronischen Bauelementes ausgebildet ist, und ein zweiter Hohlraum zumindest über einem lichtempfindlichen Bereich eines zweiten optoelektronischen Bauelements ausgebildet sein.

Das hat den Vorteil, dass der lichtemittierende Bereich von dem lichtempfindlichen Bereich abgetrennt werden kann. Es ist somit möglich, den lichtemittierenden Bereich getrennt von dem lichtempfindlichen Bereich zu kontaktieren, zu verkapseln oder anzukoppeln.

Gemäß einer weiteren bevorzugten Ausführungsform der Erfindung kann der Gehäusebehälter zwischen dem ersten und dem zweiten Hohlraum eine Trennwand aufweisen.

Eine solche Trennwand erleichtert das separate Verkapseln der beiden Hohlräume und vereinfacht ein Justieren eines optischen Verbinders zu dem ersten bzw. zu dem zweiten Hohlraum. Hiermit kann die Justiergenauigkeit zwischen einem optischen Verbinder und einem lichtemittierenden Bereich bzw. einem lichtempfindlichen Bereich der optoelektronischen Bauelementanordnung verbessert werden.

In einer besonders bevorzugten Ausführungsform der Erfindung kann die Trennwand eine Oberkante aufweisen, auf der wenigstens ein Vorsprung vorgesehen ist.

Mit einem solchen Vorsprung können Toleranzen zwischen der Höhe der Trennwand und der Höhe der Gehäuseseitenwände ausgeglichen werden.

Vorzugsweise kann der Vorsprung in Wandausrichtung einen etwa dreieckigen Querschnitt aufweisen.

Damit kann sich die Spitze des Dreiecks in die Abdeckung eindrücken, was der Vorrichtung eine zusätzliche Stabilität verleiht.

In einem bevorzugten Beispiel der Erfindung können die Hohlräume des Gehäusebehälters so mit der Abdeckung verschlossen sein, dass ein erster in der Abdeckung vorgesehener Lichtwellenleiter über dem lichtemittierenden Bauelement angeordnet ist und ein zweiter in der Abdeckung vorgesehener Lichtwellenleiter über dem lichtempfindlichen Bauelement angeordnet ist. So können getrennt voneinander wenigstens zwei Lichtwellenleiter mit jeweils dem lichtemittierenden Bauelement der Bauelementanordnung bzw. dem lichtempfindlichen Bauelement der Bauelementanordnung verbunden werden. Dadurch kann eine getrennte Signalverarbeitung empfangener und gesendeter Signale erfolgen.

Vorteilhafterweise können der erste Lichtwellenleiter und/oder der zweite Lichtwellenleiter in der Abdeckung verschweißt sein. Der Deckel kann beispielsweise aus einem Kunststoff gespritzt werden, der für eine Laserschweißdiodenwellenlänge transparent ist, für die Wellenlängen der Sende- und Empfängerelemente aber im Wesentlichen undurchsichtig.

Dies ermöglicht es, dass die Lichtwellenleiter fest mit der Abdeckung verbunden sind, was dem optoelektronischen Modul eine erhöhte Stabilität und Reproduzierbarkeit verleiht.

In einem besonders bevorzugten Beispiel der Erfindung können die Hohlräume mit einem Epoxidharz gefüllt sein.

Dieses Epoxidharz kann die Hohlräume so verschließen, dass die Bauelementanordnung gegenüber Flüssigkeit und Schmutz geschützt ist.

Die Aufgabe wird weiter erfindungsgemäß mit einem optoelektronischen Modul gelöst, das eine optoelektronische Bauelementanordnung aufweist, die auf einem Trägerelement mit wenigstens einer Leitbahn aufgebracht ist und in elektrischen Kontakt gebracht ist, wobei auf der Bauelementanordnung eine Abdeckung vorgesehen ist, welche über einem lichtemittierenden oder einem lichtempfindlichen Bereich der Bauelementanordnung eine Öffnung aufweist, in die ein optischer Verbinder einkoppelbar ist, dadurch gekennzeichnet, dass die Bauelementanordnung und das Trägerelement so mit einem aushärtbarem Material umgossen sind, dass ein Gießkörper ausgebildet ist, wobei der Gießkörper von einer umspritzten Gehäuseabdeckung ummantelt ist.

Dabei kann die Bauelementanordnung auf herkömmliche und damit kostengünstige Weise auf das Trägerelement aufgebracht werden. Der um die Bauelementanordnung und das Trägerelement ausgebildete Gießkörper schützt die Bauelementanordnung und das Trägerelement so, dass die den Gießkörper ummantelnde Gehäuseabdeckung justiergenau auf den Gießkörper aufgebracht werden kann, ohne die Bauelementanordnung oder das Trägerelement zu beeinträchtigen. Somit ist auf einfache Weise ein hochgenaues Justieren der Bauelementanordnung zu einem optischen Verbinder möglich. Die umspritzte Kunststoffabdeckung kann zudem hochpräzise in ihren äußeren Abmessungen hergestellt werden, so dass eine Anbindung beispielsweise an periphere Geräte oder ein Einbringen in andere Gehäuse leicht möglich ist.

In einer vorteilhaften Ausführungsform der Erfindung kann das aushärtbare Material Epoxidharz und/oder ein Gel sein.

Das Epoxidharz und/oder das Gel können die Bauelementanordnung und das Trägerelement fließend verkapseln und daraufhin ausgehärtet werden, so dass ein guter und stabiler Schutz der Bauelementanordnung und des Trägerelementes vor Umwelteinflüssen gewährleistet wird.

Gemäß einer weiteren bevorzugten Ausführungsform der Erfindung kann die Öffnung in einer Oberfläche der umspritzten Gehäuseabdeckung ausgebildet sein.

Damit lässt sich die Öffnung beispielsweise durch Verwenden einer Stempelanordnung auf der Oberfläche leicht in die Gehäuseabdeckung integrieren und somit genau zu der Bauelementanordnung ausrichten.

Vorzugsweise kann in der Öffnung ein Ringschnappverschluss zum Aufnehmen des optischen Verbinders integriert sein.

Damit kann der optische Verbinder leichter und stabiler in der Öffnung festgehalten werden und durch ein einfaches Verdrehen aus der Öffnung wieder entfernt werden.

Die Aufgabe wird weiterhin erfindungsgemäß mit einem Verfahren zum Herstellen eines optoelektronischen Moduls mit einer optoelektronischen Bauelementanordnung auf einem Trägerelement gelöst, die eine Abdeckung mit einer Öffnung über der Bauelementanordnung aufweist, in die ein optischer Verbinder einkoppelbar ist, wobei das Verfahren folgende Schritte umfasst: thermoplastisches Umspritzen des Trägerelementes, um einen Gehäusebehälter auszubilden; Aufbringen wenigstens eines optoelektronischen Bauelementes und wenigstens eines elektronischen Steuerschaltkreises auf das Trägerelement; elektrisches Kontaktieren des wenigstens einen optoelektronischen Bauelementes und des wenigstens einen elektronischen Steuerschaltkreises mit Leitbahnen des Trägerelementes; Abdecken des elektronischen Steuerschaltkreises mit einem Passivierungsmaterial; Abdecken zumindest des optoelektronischen Bauelementes mit einem Gel; und Aufbringen der Abdeckung auf das umspritzte Trägerelement, so dass sich die Öffnung über einer optoelektronischen Wirkfläche des optoelektronischen Bauelementes befindet.

Mit diesem Verfahren kann in wenigen, einem konventionellen Prozessablauf angepassten und damit kostengünstigen, Schritten ein optoelektronisches Modul zur Verfügung gestellt werden, bei dem die Öffnung der Abdeckung sehr genau über der optoelektronischen Wirkfläche des optoelektronischen Bauelementes vorgesehen werden kann. Damit kann eine sehr genaue Justierung des optischen Verbinders zu der Bauelementanordnung erfolgen. Mit dem thermoplastischen Umspritzen des Trägerelementes wird nicht nur die Bauelementanordnung und das Trägerelement geschützt, sondern auch eine Justiergrundlage für die nachfolgenden Schritte geschaffen. Dies ermöglicht eine enge Toleranzkette zwischen den einzelnen Verfahrensschritten, wodurch das optoelektronische Modul mit einem hohen Grad an Genauigkeit und Reproduzierbarkeit hergestellt werden kann, was auch eine leichtere weil definiertere Anbindung an weitere Vorrichtungen oder Module ermöglicht.

In einem bevorzugten Beispiel der Erfindung kann das Umspritzen des Trägerelementes ein Einbringen des Trägerelementes in ein Formwerkzeug umfassen.

Mit Hilfe des Formwerkzeuges kann der Gehäusebehälter mit reproduzierbaren Abmaßen und Toleranzen gefertigt werden. Zudem kann der gefertigte Gehäusebehälter leicht aus einem Formwerkzeug entfernt werden.

In einer besonders bevorzugten Ausführungsform der Erfindung kann das Aufbringen ein Aufkleben des optoelektronischen Bauelementes und/oder des elektronischen Steuerschaltkreiss auf das Trägerelement umfassen.

Hiermit kann das optoelektronische Bauelement und/oder der elektronische Steuerschaltkreis fest und langzeitstabil auf einer festgelegten Position des Trägerelementes festgehalten werden.

Vorzugsweise kann das elektrische Kontaktieren ein Drahtbonden umfassen.

Mit dem Drahtbonden können auch in dem vorgefertigten Gehäusebehälter hochgenaue elektrische Verbindungen zwischen den Kontakten der jeweiligen Bauelemente und den Leitbahnen des Trägerelementes hergestellt werden.

In einer günstigen Variante der Erfindung kann das Abdecken des elektronischen Steuerschaltkreises mit einem Passivierungsmaterial ein Aufbringen eines globtop-Materials umfassen, das UV-undurchlässig und elektrisch isolierend ist.

Hiermit wird erreicht, dass der Steuerschaltkreis vor schädlicher UV-Strahlung und elektrischen äußeren Einflüssen geschützt wird.

Es wird weiter vorgeschlagen, dass das Abdecken des elektronischen Bauelementes ein Aushärten des Gels umfasst.

Nach dem Aushärten des Gels verbleibt dieses in seiner Position, in der es wenigstens das optoelektronische Bauelement abdeckt, wodurch eine stabile Anordnung erzeugt wird.

Vorteilhafterweise kann die Erfindung so ausgestaltet sein, dass das Aufbringen einer Abdeckung ein Aufschieben eines Schiebedeckels auf den Gehäusebehälter umfasst.

Ein Schiebedeckel kann den Gehäusebehälter auf einfache Weise ummanteln und somit dem Gehäusebehälter nicht nur einen zusätzlichen Schutz verleihen, sondern auch die in der Abdeckung vorgehene Öffnung auf dem Gehäusebehälter über der optoelektronischen Bauelementanordnung exakt positionieren.

Als weitere vorteilhafte Variante der Erfindung wird vorgeschlagen, dass das Aufbringen der Abdeckung ein Verschweißen der Abdeckung mit dem Gehäusebehälter umfasst.

Hierdurch wird erreicht, dass eine feste Verbindung zwischen Abdeckung und Gehäusebehälter entsteht, wodurch Umwelteinflüsse, wie Feuchtigkeit oder Schmutz, insbesondere nicht in das Innere des Gehäusebehälters eindringen können, wodurch die darin befindliche Bauelementanordnung geschützt wird.

Gemäß einem vorteilhaften Beispiel der Erfindung können beim thermoplastischen Umspritzen wenigstens zwei getrennte Gehäusebehälterbereiche ausgeformt werden, wobei wenigstens zwei Bereiche des Trägerelementes voneinander separiert werden; kann das Aufbringen und das Kontaktieren der Bauelemente ein Aufbringen und ein Kontaktieren wenigstens eines lichtemittierenden Bauelementes auf einem ersten Bereich des Trägerelementes und wenigstens eines lichtempfindlichen Bauelementes auf einem zweiten Bereich des Trägerelementes umfassen; und beim Aufbringen der Abdeckung eine Gehäuseabdeckung, die wenigstens zwei Lichtwellenleiter umfasst, so auf dem Gehäusebehälter aufgebracht werden, dass der erste Lichtwellenleiter über dem lichtemittierenden Bauelement angeordnet wird und der zweite Lichtwellenleiter über dem lichtempfindlichen Bauelement angeordnet wird.

Hiermit kann der lichtempfindliche von dem lichtemittierenden Bereich effektiv bereits zu Beginn des Verfahrens durch das thermoplastische Umspritzen getrennt werden. Es ist somit möglich, die beiden Bereiche getrennt anzusteuern, zu verkapseln oder an Lichtwellenleiter anzukoppeln, was eine getrennte Signalverarbeitung in einem optoelektronischen Modul erleichtert.

Die Aufgabe wird weiterhin durch ein Verfahren zum Herstellen eines optoelektronischen Moduls mit einer optoelektronischen Bauelementanordnung auf einem Trägerelement gelöst, die eine Abdeckung mit einer Öffnung über der Bauelementanordnung aufweist, in die ein optischer Verbinder einkoppelbar ist, wobei das Verfahren ein Aufbringen und elektrisches Kontaktieren wenigstens eines optoelektronischen Bauelementes und eines elektronischen Steuerschaltkreises auf dem Trägerelement umfasst, dadurch gekennzeichnet, dass das Verfahren weiter umfasst: Umgießen des Trägerelementes und der Bauelemente mit einem aushärtenden Material, um einen Gießkörper auszubilden; thermoplastisches Umspritzen des Gießkörpers, um um den Gießkörper eine Gehäuseabdeckung auszubilden, wobei in der Gehäuseabdeckung die Öffnung über dem optoelektronischen Wirkbereich des wenigstens einem optoelektronischen Bauelementes erzeugt wird.

Hiermit wird ein einfaches Verfahren mit wenigen Verfahrensschritten, die sich an herkömmliche Technologieschritte anlehnen und damit kostengünstig sind, zur Verfügung gestellt. Die Bauelemente können hierbei auf herkömmliche Weise auf das Trägerelement aufgebracht werden. Mit dem Umgießen des Trägerelementes und der Bauelemente wird ein Gießkörper ausgebildet, der das Trägerelement und die Bauelemente schützt und gleichzeitig eine justiergenaue Basis für das sich anschließende thermoplastische Umspritzen des Gießkörpers ausbildet. Da die Bauelemente und das Trägerelement geschützt sind, kann das thermoplastische Umspritzen des Gießkörpers auf einfache Art und Weise erfolgen, wodurch insbesondere die Justiergenauigkeit der Öffnung über dem optoelektronischen Wirkbereich wenigstens eines optoelektronischen Bauelementes erleichtert wird. Das umspritzte Abdeckungsgehäuse kann zudem mit sehr geringen Fertigungstoleranzen gefertigt werden, so dass eine leicht äußere Anbindung an weitere Vorrichtungsmodule oder Gehäuseeinheiten möglich ist.

Ausführungsformen der Erfindung werden in den Figuren der Zeichnung dargestellt und nachstehend erläutert.

Es zeigen:
- Figur 1: eine erste Ausführungsform eines erfindungsgemäßen optoelektronischen Moduls in perspektivischer Ansicht;
- Figur 2: die Ausführungsform von Figur 1 entlang der Linie ll-ll von Figur 1 in einer Querschnittsansicht;
- Figur 3: eine zweite Ausführungsform eines erfindungsgemäßen optoelektronischen Moduls in perspektivischer Ansicht ohne Abdeckung;
- Figur 4: die Ausführungsform von Figur 3 entlang der Linie IV-IV von Figur 3 in der Querschnittsansicht mit der Abdeckung und angeschlossenen Lichtwellenleitern;
- Figur 5: eine erste Ausführungsform eines erfindungsgemäßen Verfahrens zum Herstellen eines optoelektronischen Moduls anhand verschiedener Herstellungsstadien der ersten Ausführungsform des erfindungsgemäßen optoelektronischen Moduls; und
- Figur 6: eine zweite Ausführungsform eines erfindungsgemäßen Verfahrens zum Herstellen eines optoelektronischen Moduls anhand verschiedener Herstellungsstadien der zweiten Ausführungsform des erfindungsgemäßen optoelektronischen Moduls.

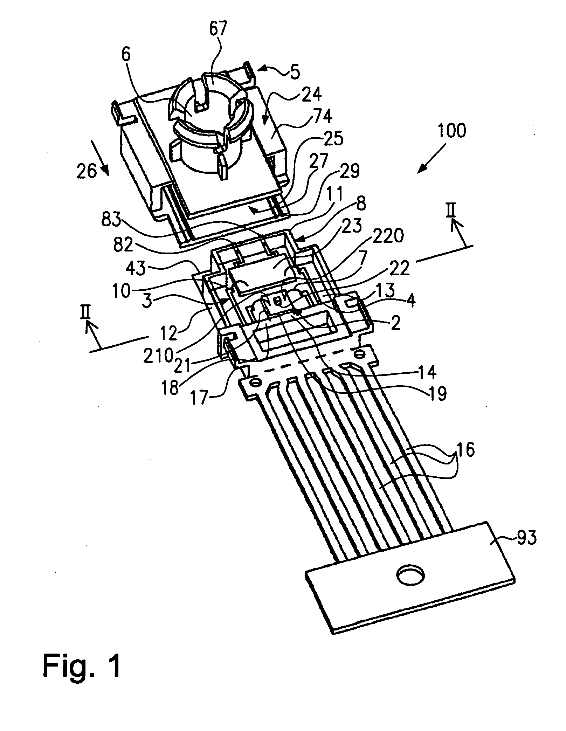

Figur 1 zeigt eine erste Ausführungsform des erfindungsgemäßen optoelektronischen Moduls 100 in perspektivischer Ansicht. Das optoelektronische Modul 100 weist ein Trägerelement 3 mit Leitbahnen 4 auf. Das in Figur 1 dargestellte Trägerelement 3 ist ein gestanzter Trägerstreifen (leadframe). Es ist jedoch auch möglich, anstatt des Trägerstreifens eine gedruckte Leiterplatte oder wenigstens einen Teil einer gedruckten Leiterplatte zu verwenden.

Auf dem Trägerelement 3 ist eine optoelektronische Bauelementanordnung 2 aufgebracht. Die einzelnen Bauelemente der optoelektronischen Bauelementanordnung sind mit einem Kleber auf dem Trägerstreifen befestigt. Die optoelektronische Bauelementanordnung 2 weist einen Transceiver auf, der aus einem Receiver 21 in Form einer Fotodiode und einem Transmitter 22 in Form einer Lichtemitterdiode (LED) besteht. Dabei ist der Transmitter auf dem Receiver angeordnet.

Beabstandet von dem Transceiver ist ein elektronischer Steuerschaltkreis 23 auf das Trägerelement 3 geklebt. Der elektronische Steuerschaltkreis 23 ist in der dargestellten Abbildung ein ELMOS-Chip, der die LED-Treiberschaltung, den Empfangsverstärker mit Peak-Detektion zur Umwandlung des Fotostroms in digitale Pegel sowie einige Logikfunktionen, wie Dauerlichtabschaltung und Synchronisierungspuls-Erkennung aufweist. Außerdem ist eine Fotostromdiagnose zur Überwachung der optischen Übertragungsqualität integriert.

Die Bauelemente 21, 22, 23 sind jeweils mit Bonddrähten 7 mit den Leitbahnen 4 des Trägerelementes 3 verbunden.

Um das Trägerelement 3 ist ein thermoplastisch ausgeformter Gehäusebehälter 8 ausgebildet. Der Gehäusebehälter 8 bildet unterhalb des Trägerelementes 3 einen Gehäuseboden 10 aus. Weiterhin umschließt der Gehäusebehälter 8 mit etwa im rechten Winkel zu dem Trägerelement 3 aufgerichteten Rahmen- bzw. Gehäuseseiten 12 das Trägerelement. Die Rahmenseiten 12 bilden einen Gehäuserahmeninnenraum 13 in Form eines Hohlraums aus, in dem sich das Trägerelement 3 und die darauf gebondeten Bauelemente befinden. Dabei ist die Oberseite des Trägerelementes 3 mit den darauf befindlichen Bauelementen von der nach oben offenen Seite des Gehäuserahmeninnenraums 13 zugänglich.

Im Gehäuserahmeninnenraum 13 sind Versteifungsrippen 14 ausgebildet. In Figur 1 verläuft eine Versteifungsrippe 14 von einer Rahmenseite 12 zu einer gegenüberliegenden Rahmenseite 12. Es ist jedoch auch denkbar, dass wenigstens zwei Versteifungsrippen 14 in dem Gehäuserahmeninnenraum 13 angeordnet sind. Dabei können die Versteifungsrippen 14 gekreuzt angeordnet sein.

Der Gehäusebehälter 8 bildet etwa die Form eines Schubfaches aus. Dabei sind die Seitenkantenbereiche 17 einer Rahmenseite 12 seitlich verlängert ausgebildet. Weiterhin weist der Gehäusebehälter 8 an wenigstens einer Rahmenseite 12 Durchführungen 15 für Leitbahnanschlüsse 16 an die Leitbahnen 4 auf. An einer weiteren Rahmenseite 12 befinden sich ein Kühlungsanschluss 82, der mit dem Trägerelement 3 verbunden ist, und ein elektromagnetischer Schirmungsanschluss 83, der ebenfalls mit dem Trägerelement 3 verbunden ist.

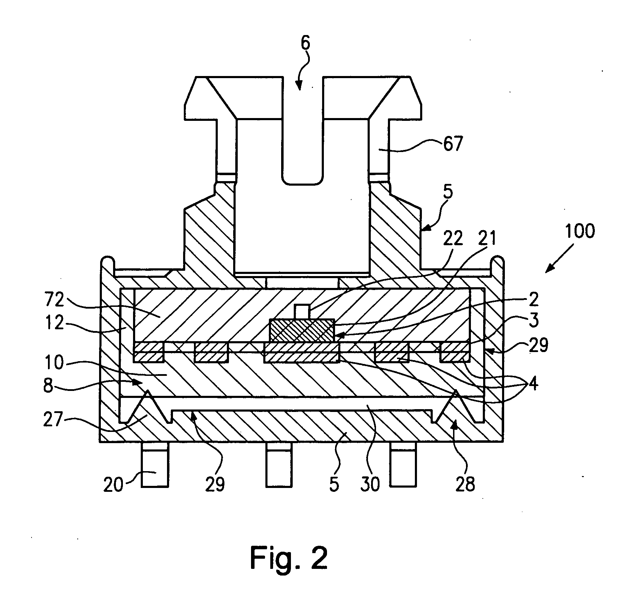

Die Leitbahnen 4 sind durch die Durchführungen 15 mit den Leitbahnanschlüssen 16 verbunden. In Figur 1 sind als Leitbahnanschlüsse mehrere parallel zueinander ausgebildete feste Leiterzüge vorgesehen, die während der Aufbau und Verbindungstechnologie mit einem Halteelement 93 geklammert sind. Anstatt dessen kann auch, wie in Figur 2 gezeigt, eine Stiftleiste 20 verwendet werden.

Die Versteifungsrippe 14 bildet zudem ein Referenzelement 18 aus, welches an seiner den Bauelementen zugewandten Seite eine Kunststoffkante 19 besitzt. Diese Kunststoffkante 19 bildet gemeinsam mit dem Gehäuserahmen 11 eine Referenz, nach der die einzelnen Bauelemente 21, 22, 23 in den Gehäusebehälter 8 auf das Trägerelement 3 aufgebracht werden können. Da der Gehäusebehälter in einem Formwerkzeug (nicht dargestellt) mit hoher Präzision gefertigt wird, können demnach die Bauelemente mit hoher Genauigkeit innerhalb des Gehäuserahmens 11 und relativ zu der Kunststoffkante 19 sehr genau positioniert werden.

Figur 1 zeigt weiterhin einen nicht innerhalb des umspritzten Bereiches des Trägerelementes 3 befindlichen Abschnitt 43 des Trägerelementes 3. Auf dem Abschnitt 43 können weitere Bauelemente oder Vorrichtungen (nicht gezeigt) vorgesehen sein, welche nicht abgedeckt werden sollen.

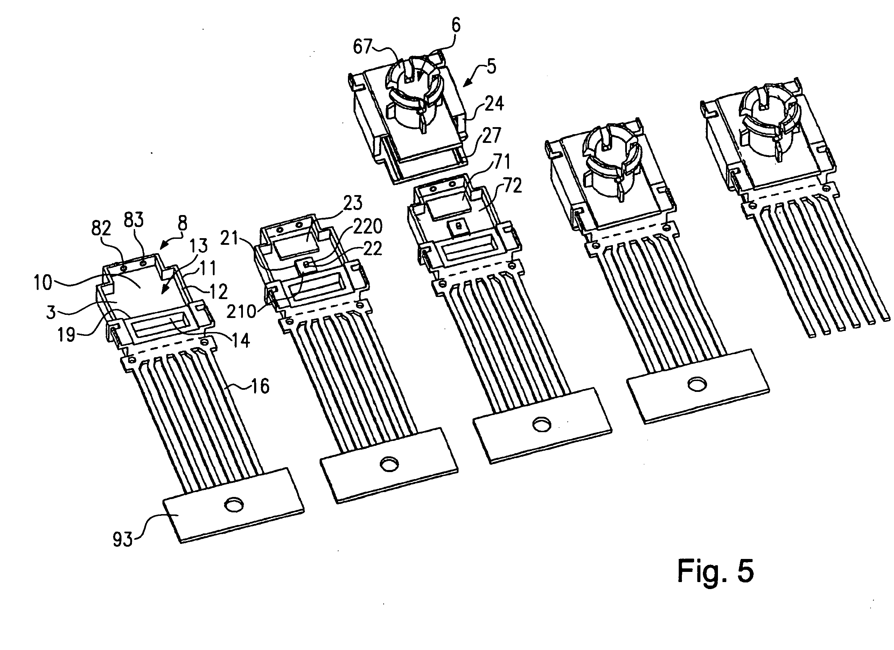

Auf dem elektronischen Steuerschaltkreis 23 ist eine in Figur 5 gezeigte Passivierungsschicht 71 vorgesehen. Die Passivierungsschicht ist ein globtop-Material, das UV-undurchlässig und elektrisch isolierend ist. Oberhalb der gesamten optoelektronischen Bauelementanordnung 2 ist der Gehäuseinnenraum 13 mit einem Gel 72 aufgefüllt. Dabei reicht die Oberfläche des aufgefüllten Gels 72 bis an die Oberkanten der jeweiligen Rahmenseiten 12.

In Figur 1 ist weiterhin eine Abdeckung 5 dargestellt, die als ein Schiebedeckel 24 ausgebildet ist. Der Schiebedeckel 24 ist etwa wie die Hülle einer Streichholzschachtel auf den Gehäusebehälter 8 aufgeschoben. Dabei ist eine in der Oberfläche des Schiebedeckels 24 befindliche Öffnung 6 direkt oberhalb der optoelektronischen Bauelementanordnung 2 platziert.

Die Öffnung 6 weist einen Ringschnapphaken 67 auf, in den ein optischer Verbinder, beispielsweise ein Lichtwellenleiter 41, 42, einkoppelbar ist.

In der mit 26 bezeichneten Schieberichtung des Schiebedeckels 24 sind innerhalb eines Schiebedeckelinnenraums 25 längs der Schieberichtung 26 Schienen 27 ausgebildet. Die Schienen 27 dienen dem Ausgleich von Herstellungstoleranzen, indem sie den Gehäusebehälter 8 zu der Öffnung 6 in dem Schiebedeckel 24 hindrücken. Die Schienen 27 weisen einen etwa dreieckigen Querschnitt 28 auf. Anstatt der Schienen 27 sind auch andere Toleranzausgleichselemente 29, beispielsweise in Form von Vorsprüngen oder Aussparungen am Gehäusebehälter 8 oder an der Abdeckung 5, wie sie in Fig. 2 dargestellt sind, denkbar.

Weiterhin weist der Schiebedeckel (24) nicht dargestellte Führungen in Form von Vorsprüngen oder Schienen im Schiebedeckelinnenraum (25) auf, die in entsprechend ausgeformte Führungsgegenstücke, die am Gehäusebehälte (8), beispielsweise in Form von Aussparungen oder Schienenführungen ausgebildet sind, eingreifen.

Außerdem ist die Außenwand des Gehäusebehälters (8) als auch des Schiebedeckels (24) mit einer leitfähigen Schicht (74) versehen.

Figur 2 zeigt die erste Ausführungsform des erfindungsgemäßen optoelektronischen Moduls entlang der Linie ll-ll von Figur 1, wobei die Blickrichtung in Pfeilrichtung ist und der Schiebedeckel 24 auf den Gehäusebehälter aufgeschoben ist.

Figur 2 zeigt den innerhalb des Gehäuserahmeninnenraums 13 befindlichen Aufbau aus dem Trägerelement 3 und den darauf befindlichen Bauelementen, wobei der Transmitter 22 in einer Chip-on-Chip-Technologie über dem Receiver 21 des Transceivers angeordnet ist. Zwischen dem Gehäuseboden 10 und dem der Öffnung 6 der Abdeckung 5 gegenüber befindlichen Teil der Abdeckung 5 ist ein Freiraum 30 ausgebildet.

Die Toleranzausgleichselemente 29 einschließlich der beidseitig ausgebildeten Schienen 27 drücken den Gehäusebehälter 8 so mit seiner Oberfläche gegen den Öffnungsbereich, dass nahezu kein Spalt zwischen einem in die Öffnung 6 einbringbaren Lichtwellenleiter 41, 42 (in Figur 2 nicht gezeigt) und der Oberfläche des Gehäusebehälters 8 besteht.

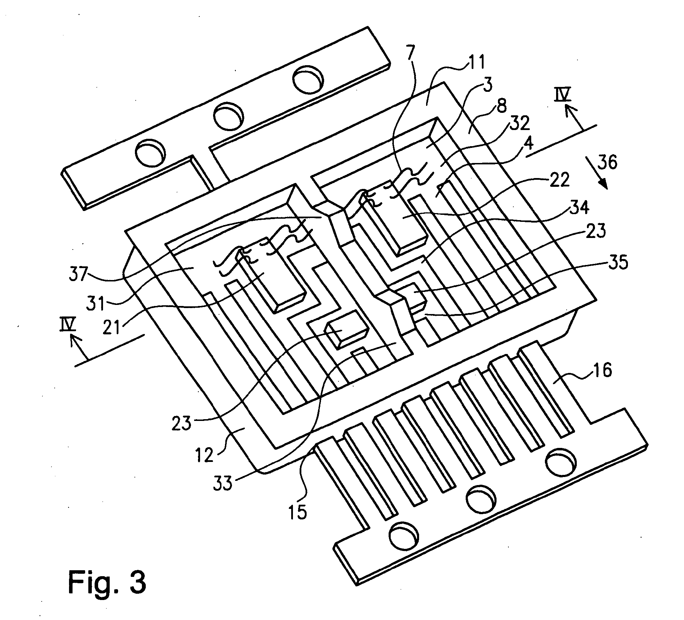

Figur 3 zeigt eine zweite Ausführungsform eines erfindungsgemäßen optoelektronischen Moduls 200 in perspektivischer Ansicht ohne die Abdeckung 5.

Bei dem optoelektronischen Modul 200 befindet sich das Trägerelement 3 in einem wannenartig ausgebildeten Gehäusebehälter 8. Dabei ist der Gehäusebehälter 8 um das Trägerelement 3 so gespritzt, dass sich unterhalb des Trägerelementes 3 ein in Fig. 3 nicht gezeigter Gehäuseboden 10 ausbildet. Dabei wird das Trägerelement 3 an vier Seiten von den Rahmenseiten 12 so umringt, dass sich ein etwa rechteckiger Gehäuserahmen 11 um das Trägerelement 3 ausbildet.

Der Gehäusebehälter 8 ist derart zweigeteilt, dass sich etwa in der Mitte des Gehäusebehälters eine Trennwand 33 ausbildet, die einen ersten Hohlraum 31 von einem zweiten Hohlraum 32 trennt. Die Trennwand 33 hat eine Oberkante 34 auf der zwei Vorsprünge 35 mit einem in der dargestellten Wandausrichtung 36 etwa dreieckigen Querschnitt 37 aufgeformt sind.

Die Hohlräume 31 und 32 weisen eine etwa spiegelsymmetrische Leitbahn- 4 und Bauelementeanordnung 2 auf. Dabei befindet sich in dem ersten Hohlraum 31 ein lichtemittierendes Bauelement, beispielsweise eine Lichtemitterdiode 21, und im zweiten Hohlraum 32 befindet sich ein lichtempfindliches Bauelement, beispielsweise eine Fotodiode 22. Außerdem befindet sich in jedem Hohlraum ein elektronischer Steuerschaltkreis 23.

Die jeweiligen Bauelemente sind, ähnlich wie in Figur 1, mit Bonddrähten 7 mit den Leitbahnen 4 des Trägerelementes 3 verbunden, die wiederum über Durchführungen 15 in den Rahmenseiten 12 des Gehäusebehälters 8 mit Leitbahnanschlüssen 16 außerhalb des Gehäusebehälters 8 verbunden sind.

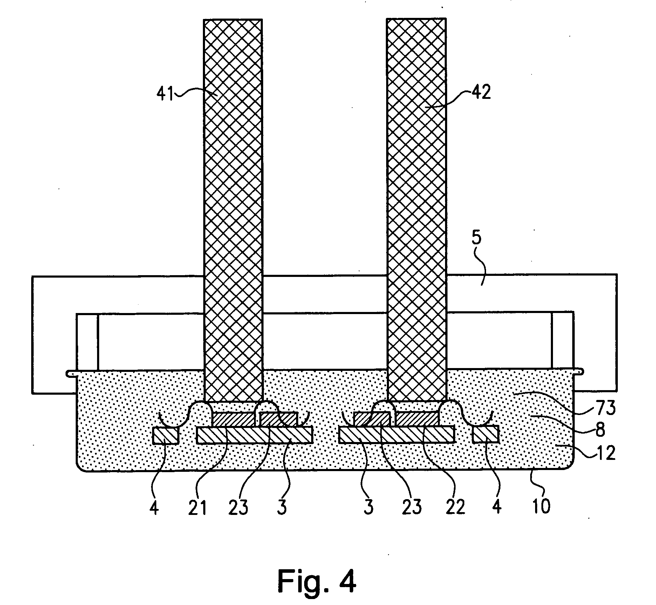

Figur 4 zeigt die zweite Ausführungsform des erfindungsgemäßen optoelektronischen Moduls von Figur 3 in einer Querschnittsansicht entlang der Linie IV-IV, wobei die angezeigte Pfeilrichtung der Blickrichtung entspricht und die Anordnung mit einer Abdeckung 5 und integrierten Lichtwellenleitern 41, 42 versehen ist.

Die in Figur 4 dargestellte Abdeckung 5 ist deckelartig über den rahmenartigen Gehäusebehälter 8 gestülpt oder geschoben. Ein erster Lichtwellenleiter 41 und ein zweiter Lichtwellenleiter 42 beabstandet zueinander in der Abdeckung 5 verschweißt. Die Lichtwellenleiter 41, 42 sind jeweils oberhalb entweder eines lichtemittierenden Bereiches 220 des Transmitters 22 im ersten Hohlraum 31 bzw. oberhalb eines lichtempfindlichen Bereichs 210 eines Receivers 21 im zweiten Hohlraum 32 angeordnet sind. In Figur 4 ist der Gehäusebehälter 8 mit einem Epoxidharz 73 vergossen. Es ist jedoch auch möglich, dass der Gehäusebehälter 8 mit einem Gel 72 vergossen wird.

Figur 5 zeigt eine erste Ausführungsform eines erfindungsgemäßen Verfahrens zum Herstellen der ersten Ausführungsform des erfindungsgemäßen optoelektronischen Moduls 100, wobei schematisch eine Abfolge verschiedener Verfahrensstadien anhand des jeweiligen Aufbaus des optoelektronischen Moduls 100 während der Fertigung gezeigt ist.

Zunächst wird ein Leadframe bzw. ein Trägerelement 3, das mit einer Verbindungsleiste 16 in Verbindung steht, so thermoplastisch umspritzt, dass ein Gehäusebehälter 8 um das Trägerelement 3 ausgebildet wird. Der Gehäusebehälter 8 bildet dabei einen Rahmen um das Trägerelement 3 aus, so dass die Sichtseite des Trägerelementes 3 für ein nachfolgendes Eindringen der optoelektronischen Bauelementanordnung 2 offen bleibt.

Daraufhin werden die Bauelemente, das heißt, der aus einem Receiver 21 und einem Transmitter 22 bestehende Transceiver und ein elektronischer Steuerschaltkreis 23 an einer Kunststoffkante 19 und den Rahmenseiten 12 des Gehäuserahmens 11 ausgerichtet und mit einem Kleber auf das Leadframe geklebt.

Dann werden die Kontakte der Bauelemente 21, 22, 23 mit den hier nicht dargestellten Leitbahnen 4 des Leadframes mittels Drahtbunden verbunden.

Daraufhin erfolgt eine Abdeckung des elektronischen Steuerschaltkreises 23 mit einem Passivierungsmaterial 71, vorzugsweise einem UV-undurchlässigen, elektrisch lichtleitfähigen globtop-Materials.

Im nächsten Schritt wird der Gehäuserahmeninnenraum 13 mit einem Gel 72 vergossen. Das Gel 72 wird ausgehärtet.

Daraufhin wird eine vorgefertigte Abdeckung 5 in Form eines Schiebedeckels 24 über den mit Gel 72 gefüllten Gehäusebehälter 8 geschoben, so dass die sich in der Abdeckung 5 befindliche Öffnung oberhalb des lichtemittierenden bzw. lichtempfindlichen Bereiches der optoelektronischen Bauelementanordnung 2 angeordnet wird. Dann wird die Abdeckung 5 seitlich mit dem Gehäusebehälter 8 verschweißt.

Daraufhin wird im letzten Schritt das Halteelement 93 entfernt, woraufhin die Leitbahnanschlüsse 16 beispielsweise in eine Steckleiste eingeführt werden können und in den in der Öffnung 6 vorgesehenen Ringschnapphaken 67 ein Lichtwellenleiter 41, 42 eingekoppelt werden kann.

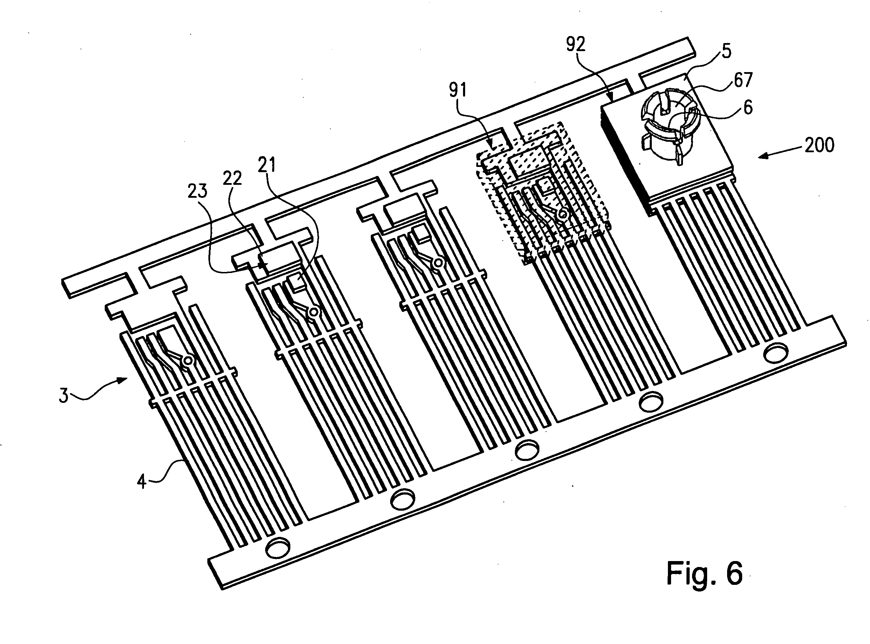

Figur 6 zeigt eine zweite Ausführungsform eines erfindungsgemäßen Verfahrens zur Herstellung der zweiten Ausführungsform des erfindungsgemäßen optoelektronischen Moduls 200. Dabei ist das Verfahren anhand einer Abfolge verschiedener Verfahrensstadien des optoelektronischen Moduls 200 in perspektivischer Ansicht dargestellt.

Zunächst werden die Bauelemente, das heißt der aus dem Receiver 21 und dem Transmitter 22 bestehende Transceiver und der elektronische Steuerschaltkreis 23 auf herkömmliche Weise auf ein Leadframe 3 mit Leitbahnen 4 aufgeklebt und gebondet.

Dann wird der elektronische Steuerschaltkreis 23 mit einem UV-undurchlässigen und elektrisch nicht leitfähigem Passivierungsmaterial (globtop) 71 abgedeckt.

Daraufhin werden das Leadframe und die darauf gebundenen Bauelemente mit einem aushärtenden Material vergossen, so dass ein etwa quaderförmiger Gießkörper 91 entsteht.

Dieser Gießkörper 91 wird ausgehärtet und daraufhin mit einer Gehäuseabdeckung 92 umspritzt, bei der oberhalb des lichtemittierenden Bereiches 220 bzw. des lichtempfindlichen Bereiches 210 der optoelektronischen Bauelementanordnung 2 eine Öffnung 6 belassen wird, wobei die Öffnung 6 einen Ringschnapphaken 67 zum Aufnehmen eines Lichtwellenleiters 41, 42 hat.

Weiterhin können an allen oben beschriebenen Ausführungsformen die folgenden Modifikationen vorgenommen werden.

Der Gehäusebehälter 8 kann einen Gehäuseboden 10 und einen Gehäuserahmen 11 mit mehreren, sich von dem Trägerelement 3 etwa im rechten Winkel erstreckenden Rahmenseiten 12 aufweisen. Dabei können die Rahmenseiten 12 einen etwa rechteckigen Gehäuserahmeninnenraum 13 ausbilden. Der Gehäuserahmen 11 kann in dem Gehäuserahmeninnenraum 13 Versteifungsrippen 14 aufweisen und es können wenigstens zwei Versteifungsrippen 14 gekreuzt angeordnet sein.

Gemäß einer weiteren Ausführungsform weist wenigstens eine Rahmenseite 12 zumindest eine Durchführung 15 für einen Leitbahnanschluss 16 der Leitbahn 4 auf. Dieser Leiterbahnanschluss 16 kann eine Stiftleiste 20 sein.

Weiterhin kann wenigstens eine Rahmenseite 12 einen Kühlungsanschluss 82 aufweist, der mit dem Trägerelement 3 verbunden ist. Eine Rahmenseite 12 kann einen Schirmungsanschluss 83 zum elektrischen oder elektromagnetischen Abschirmen der optoelektronischen Bauelementanordnung 2 aufweisen, der mit dem Trägerelement 3 verbunden ist.

Gemäß einer weiteren Modifikation kann der Gehäusebehälter 8 die Form eines Einschubfaches 81 aufweisen, bei dem eine Rahmenseite 12 im Vergleich zu der ihr gegenüberliegenden Rahmenseite beidseitig verlängerte Seitenkantenbereiche 17 aufweist.

Weiterhin kann die Kunststoffkante 19 eine Trennwand 33 zwischen einzelnen Bauelementen der optoelektronischen Bauelementanordnung 2 ausbilden. Die Höhe des Referenzelementes 18 kann geringer als die der Gehäuseseiten 12 sein.

Gemäß einer weiteren Modifikation bilden der Receiver 21 und der Transmitter 22 einen Transceiver aus, indem der Transmitter und der Receiver übereinander angeordnet sind.

Weiterhin kann der Receiver 21 eine Fotodiode sein. Der Transmitter 22 kann eine Lichtemitterdiode sein.

Gemäß einer weiteren Modifikation ist das Passivierungsmaterial 71 UV-undurchlässig. Weiterhin kann das Passivierungsmaterial 71 elektrisch isolierend sein.

Außerdem kann zumindest der Bereich des Gehäusebehälters 8, in dem sich die Bauelementanordnung 2 befindet, mit dem Gel 72 aufgefüllt sein. Dieses Gel 72 kann elastisch sein. Weiterhin kann das Gel 72 auch lichtdurchlässig sein.

Gemäß einer weiteren Ausführungsform ist die Abdeckung 5 eine Umhäusung.

Weiterhin kann das Toleranzausgleichselement 29 zwei sich in den Schiebedeckelinnenraum 25 längs der Schieberichtung 26 erstreckende Schienen 27 aufweisen. Diese Schienen 27 können einen etwa dreieckigen Querschnitt 28 aufweisen.

Darüber hinaus kann im Schiebedeckel 24 wenigstens ein Führungselement vorgesehen sein, das in ein Führungsgegenstück im Gehäusebehälter eingreift. Der Schiebedeckel 24 kann außerdem mit dem Gehäusebehälter 8 verschweißt sein.

Gemäß einer weiteren Ausführungsform weist die Trennwand 33 eine Oberkante 34 auf, auf der wenigstens ein Vorsprung 35 zum Toleranzausgleich vorgesehen ist. Dabei kann der Vorsprung 35 in Wandausrichtung 36 einen etwa dreieckigen Querschnitt 37 aufweisen.

Die Hohlräume 31, 32 des Gehäusebehälters 8 können so mit der Abdeckung 5 verschlossen sein, dass ein erster in der Abdeckung vorgesehener Lichtwellenleiter 41 über dem lichtemittierenden Bauelement angeordnet ist und ein zweiter in der Abdeckung vorgesehener Lichtwellenleiter 42 über dem lichtempfindlichen Bauelement angeordnet ist. Weiterhin können der erste Lichtwellenleiter 41 und der zweite Lichtwellenleiter 42 in der Abdeckung 5 verschweißt sein. Das aushärtbare Material kann Epoxidharz 73 oder ein Gel 72 sein.

An dem erfindungsgemäßen Verfahren können außerdem die oben beschriebenen Ausführungsformen mit den im folgenden aufgeführten Modifikationen abgewandelt werden. So kann das Umspritzen des Trägerelementes 3 ein Einbringen des Trägerelementes in ein Formwerkzeug umfassen.

Das Aufbringen kann ein Aufkleben des optoelektronischen Bauelementes 21, 22 und/oder des elektronischen Steuerschaltkreises 23 auf das Trägerelement 3 umfassen.

Weiterhin kann das elektrische Kontaktieren ein Drahtbonden umfassen.

Außerdem kann das Aufbringen der Abdeckung 5 ein Aufschieben eines Schiebedeckels auf den Gehäusebehälter umfassen.

Schließlich kann das Aufbringen der Abdeckung 5 ein Verschweißen der Abdeckung mit dem Gehäusebehälter 8 umfassen.

## Patentansprüche

1. Optoelektronisches Modul (100), das eine optoelektronische Bauelementanordnung (2) aufweist, die auf einem Trägerelement (3) und wenigstens einer Leitbahn (4) aufgebracht und mit der Leitbahn elektrisch kontaktiert ist, wobei auf der Bauelementanordnung eine Abdeckung (5) vorgesehen ist, welche über einem lichtemittierenden Bereich (210) oder einem lichtempfindlichen Bereich (220) der Bauelementanordnung eine Öffnung (6) aufweist, in die ein optischer Verbinder (41, 42) einkoppelbar ist,
**dadurch gekennzeichnet, dass**
das Trägerelement (3) thermoplastisch umspitzt ist, um einen Gehäusebehälter (8) auszubilden, in den die Bauelementanordnung (2) einbringbar ist.

2. Optoelektronisches Modul nach Anspruch 1, **dadurch gekennzeichnet, dass** das Trägerelement (3) ein gestanzter Trägerstreifen oder wenigstens ein Teil einer gedruckten Leiterplatte ist.

3. Optoelektronisches Modul nach wenigstens einem der vorhergehenden Ansprüche, **dadurch gekennzeichnet, dass** das Trägerelement (3) so thermoplastisch umspritzt ist, dass das Trägerelement so in den Gehäusebehälter (8) eingebettet ist, dass die Oberfläche des Trägerelementes offen liegt.

4. Optoelektronisches Modul nach wenigstens einem der vorhergehenden Ansprüche, **dadurch gekennzeichnet, dass** das Trägerelement (3) so thermoplastisch umspritzt ist, dass wenigstens ein Abschnitt (43) des Trägerelementes außerhalb des umspritzten Bereiches ist.

5. Optoelektronisches Modul nach wenigstens einem der vorhergehenden Ansprüche, **dadurch gekennzeichnet, dass** das Trägerelement (3) ein Referenzelement (18) zum Ausrichten der optoelektronischen Bauelementanordnung (2) auf dem Trägerelement aufweist.

6. Optoelektronisches Modul nach Anspruch 14, **dadurch gekennzeichnet, dass** das Referenzelement (18) eine innerhalb des Gehäusebehälters (8) ausgebildete Kunststoffkante (19) ist.

7. Optoelektronisches Modul nach wenigstens einem der vorhergehenden Ansprüche, **dadurch gekennzeichnet, dass** die Bauelementanordnung (2) wenigstens einen Receiver (21) und/oder einen Transmitter (22) aufweist.

8. Optoelektronisches Modul nach wenigstens einem der vorhergehenden Ansprüche, **dadurch gekennzeichnet, dass** die Bauelementanordnung (2) wenigstens einen elektronischen Steuerschaltkreis (23) aufweist.

9. Optoelektronisches Modul nach Anspruch 22, **dadurch gekennzeichnet, dass** de Steuerschaltkreis (23) mit einem Passivierungsmaterial (71) abgedeckt ist.

10. Optoelektronisches Modul nach wenigstens einem der vorhergehenden Ansprüche, **dadurch gekennzeichnet, dass** die Bauelementanordnung (2) mit einem Gel (72) abgedeckt ist.

11. Optoelektronisches Modul nach wenigstens einem der vorangehenden Ansprüche, **dadurch gekennzeichnet, dass** die Abdeckung in Form eines Schiebedeckels (24) ausgebildet ist, der auf den Gehäusebehälter (8) aufgeschoben ist, dass sich seine Öffnung (6) über dem lichtemittierenden Bereich (220) oder dem lichtempfindlichen (210) Bereich der optoelektronischen Bauelementanordnung (2) befindet.

12. Optoelektronisches Modul nach Anspruch 11, **dadurch gekennzeichnet, dass** der Schiebedeckel (24) wenigstens ein Toleranzausgleichselement (29) aufweist, das den Gehäuserahmen (8) mit seiner Sichtseite gegen die Öffnungsseite des Schiebedeckels drückt.

13. Optoelektronisches Modul nach Anspruch 12, **dadurch gekennzeichnet, dass** der Schiebedeckel (24) an der Öffnung einen Ringschnapphaken (67) zum Aufnehmen des optischen Verbinders (41, 42) aufweist.

14. Optoelektronisches Modul nach wenigstens einem der Ansprüche 12 oder 13, **dadurch gekennzeichnet, dass** der Schiebedeckel (24) und/oder Gehäusebehälter (8) zumindest teilweise mit einer leitfähigen Schicht (74) beschichtet sind.

15. Optoelektronisches Modul nach wenigstens einem der vorhergehenden Ansprüche, **dadurch gekennzeichnet, dass** der Gehäusebehälter (8) wenigstens zweigeteilt ist, wobei ein erster Hohlraum (31) zumindest über einen lichtemittierenden Bereich (210) eines ersten optoelektronischen Bauelementes ausgebildet ist, und ein zweiter Hohlraum (32) zumindest über einem lichtempfindlichen Bereich (220) eines zweiten optoelektronischen Bauelementes ausgebildet ist.

16. Optoelektronisches Modul nach Anspruch 15, **dadurch gekennzeichnet, dass** der Gehäusebehälter (8) zwischen dem ersten Hohlraum (31) und dem zweiten Hohlraum (32) eine Trennwand (33) aufweist.

17. Optoelektronisches Modul nach wenigstens einem der Ansprüche 15 oder 16, **dadurch gekennzeichnet, dass** die Hohlräume (31, 32) mit einem Epoxidharz (73) gefüllt sind.

18. Optoelektronisches Modul (200), das eine optoelektronische Bauelementanordnung (2) aufweist, die auf einem Trägerelement (3) mit wenigstens einer Leitbahn (4) aufgebracht ist und in elektrischen Kontakt gebracht ist, wobei auf der Bauelementanordnung eine Abdeckung (5) vorgesehen ist, welche über einem lichtemittierenden Bereich (210) oder einem lichtempfindlichen Bereich (220) der Bauelementanordnung eine Öffnung (6) aufweist, in die ein optischer Verbinder (41, 42) einkoppelbar ist, **dadurch gekennzeichnet, dass** die Bauelementanordnung (2) und das Trägerelement (3) so mit einem aushärtbaren Material umgossen sind, dass ein Gießkörper (91) ausgebildet ist, wobei der Gießkörper von einem umspritzten Abdeckungsgehäuse (92) ummantelt ist.

19. Optoelektronisches Modul nach Anspruch 18, **dadurch gekennzeichnet, dass** die Öffnung (6) in einer Oberfläche der umspritzten Gehäuseabdeckung (92) ausgebildet ist und dass in der Öffnung (6) ein Ringschnappverschluss (67) zum Aufnehmen des optischen Verbinders (41, 42) integriert ist.

20. Verfahren zum Herstellen eines optoelektronischen Moduls (100) mit einer optoelektronischen Bauelementanordnung (2) auf einem Trägerelement (3), die eine Abdeckung (5) mit einer Öffnung (6) über der Bauelementanordnung aufweist, in die ein optischer Verbinder (41, 42) einkoppelbar ist, **dadurch gekennzeichnet, dass** das Verfahren folgende Schritte umfasst:
thermoplastisches Umspritzen des Trägerelementes (3), um einen Gehäusebehälter (8) auszubilden;
Aufbringen wenigstens eines optoelektronischen Bauelementes (21, 22) und wenigstens eines elektronischen Steuerschaltkreises (23) auf das Trägerelement (3);
elektrisches Kontaktieren des wenigstens einen optoelektronisches Bauelementes und des wenigstens einen elektronischen Steuerschaltkreises (23) mit Leitbahnen (4) des Trägerelementes (3),
Abdecken des elektronischen Steuerschaltkreises (23) mit einem Passivierungsmaterial (71),
Abdecken zumindest des optoelektronischen Bauelementes (21, 22) mit einem Gel (72),
Aufbringen der Abdeckung (5) auf das umspritzte Trägerelement (3), so dass sich die Öffnung (6) über einer optoelektronischen Wirkfläche des optoelektronischen Bauelementes (21, 22) befindet.

21. Verfahren nach Anspruch 20, **dadurch gekennzeichnet, dass** das Abdecken des elektronischen Steuerschaltkreises (23) mit einem Passivierungsmaterial (71) ein Aufbringen eines globtop-Materials umfasst, das UV-undurchlässig und elektrisch isolierend ist.

22. Verfahren nach wenigstens einem der Ansprüche 20 oder 21, **dadurch gekennzeichnet, dass** das Abdecken des optoelektronischen Bauelementes (21, 22) ein Aushärten des Gels (72) umfasst.

23. Verfahren nach wenigstens einem der Ansprüche 20 bis 22, **dadurch gekennzeichnet, dass**
beim thermoplastischen Umspritzen wenigstens zwei getrennte Gehäusebehälterbereiche (31, 32) ausgeformt werden, wobei wenigstens zwei Bereiche des Trägerelementes (3) voneinander separiert werden;
das Aufbringen und das Kontaktieren der Bauelemente ein Aufbringen und ein Kontaktieren wenigstens eines lichtemittierenden Bauelementes auf einem ersten Bereich des Trägerelementes (3) umfasst und wenigstens eines lichtempfindlichen Bauelementes auf einem zweiten Bereich des Trägerelementes umfasst;
beim Aufbringen der Abdeckung eine Gehäuseabdeckung (92), die wenigstens zwei Lichtwellenleiter (41, 42) umfasst, so auf dem Gehäusebehälter (8) aufgebracht wird, dass der erste Lichtwellenleiter (41) über dem lichtemittierenden Bauelement angeordnet wird und der zweite Lichtwellenleiter (42) über dem lichtempfindlichen Bauelement angeordnet wird.

24. Verfahren zum Herstellen eines optoelektronischen Moduls (200) mit einer optoelektronischen Bauelementanordnung (2) auf einem Trägerelement (3), die eine Abdeckung (5) mit einer Öffnung (6) über der Bauelementanordnung aufweist, in die ein optischer Verbinder (41, 42) einkoppelbar ist,
wobei das Verfahren ein Aufbringen und elektrisches Kontaktieren wenigstens eines optoelektronischen Bauelementes (21, 22) und eines elektronischen Steuerschaltkreises (23) auf dem Trägerelement (3) umfasst, **dadurch gekennzeichnet, dass**
das Verfahren weiter umfasst:
Umgießen des Trägerelementes (3) und der Bauelemente (21, 22, 23) mit einem aushärtenden Material, um einen Gießkörper (91) auszubilden;
thermoplastisches Umspritzen des Gießkörpers (91), um um den Gießkörper eine Gehäuseabdeckung (92) auszubilden, wobei in der Gehäuseabdeckung die Öffnung (6) über dem optoelektronischen Wirkbereich des wenigstens einen optoelektronischen Bauelementes (21, 22) erzeugt wird.
